# EUROPÄISCHE PATENTSCHRIFT

(11) **EP 2 297 768 B1**
(45) Veröffentlichungstag und Bekanntmachung des Hinweises auf die Patenterteilung: **08.08.2012**
(21) Anmeldenummer: 09768970.7
(22) Anmeldetag: 23.06.2009
(51) Int. Cl.: H01J 37/32, C23C 16/54, C23C 14/56

(54) **ANORDNUNG ZUM BESCHICHTEN BANDFÖRMIGER FOLIENSUBSTRATE**
ARRANGEMENT FOR COATING TAPE-SHAPED FILM SUBSTRATES
ENSEMBLE POUR L'APPLICATION D'UN REVETEMENT SUR DES SUBSTRATS DE TYPE FEUILLES EN FORME DE BANDES

(30) Priorität: 23.06.2008 DE 102008029379
(43) Veröffentlichungstag der Anmeldung: 23.03.2011
(73) Patentinhaber: Von Ardenne Anlagentechnik GmbH, 01324 Dresden (DE)
(72) Erfinder: GOTTSMANN, Lutz, 01900 Grossroehrsdorf (DE); PROEHL, Holger, 01324 Dresden (DE)
(74) Vertreter: Lippert, Stachow & Partner
(86) Internationale Anmeldenummer: PCT/EP2009/004515
(87) Internationale Veröffentlichungsnummer: WO 2009/156121

(56) Entgegenhaltungen:
- EP-A2- 0 661 760
- WO-A1-01/20054
- WO-A1-03/100111
- US-A- 5 589 007

## Beschreibung

Die Erfindung betrifft eine Anordnung zum Beschichten bandförmiger Foliensubstrate mit einer Abwickel- und einer Aufwickelrolle zwischen denen das Foliensubstrat unter einer Bandzugspannung geführt wird und einer dazwischen angeordneten Beschichtungsstation.

Zum Beschichten wird ein bandförmiges Foliensubstrat im Vakuum von einer Abwickelrolle über eine Beschichtungsstation geführt und durch eine Aufwickelrolle wieder aufgenommen, wie aus US5589007 bekannt.

Wie jedes im Vakuum zu beschichtende Substrat ist auch ein zu beschichtendes Foliensubstrat, die insbesondere eine Metallfolie, die eine Dicke von einigen 10µm bis einige 100µm aufweisen kann, einer Wärmebelastung ausgesetzt. Infolge der geringen Dicke treten jedoch bei derartigen Foliensubstraten hierdurch schnell Überhitzungserscheinungen auf, die regelmäßig zu Strukturveränderungen des Substrats führen. Aus diesem Grunde ist zu gewährleisten, dass eine maximale Substrattemperatur während des Transportes und der Beschichtung des Substrates, sowie Gewährleistung einer anderen geringeren maximalen Substrattemperatur nicht überschritten wird, bevor das Substrat aufgewickelt wird

Andererseits darf die zu beschichtende Seite des Substrates auch keinen mechanischen Störungen unterzogen werden, wie sie etwa durch Stütz- oder Transportrollen hervorgerufen werden können. Aus diesem Grunde ist ein Kontakt der zu beschichtenden Substratseite "Frontseite" mit Rollen oder sonstigen Anlagenteilen während des Transportes, der Beschichtung oder einer sonstigen Substratbehandlung (z.B. Kühlung) zu vermeiden.

Schließlich ist bei dem gesamten Beschichtungsvorgang ein Faltenfreies Transportieren, Beschichten und Wickeln des Substrates unter Beachtung der Substratdicke und der zulässigen Substrattemperaturen sicher zu stellen.

Der Erfindung liegt die Aufgabe zugrunde, eine Vakuumbeschichtung von Foliensubstraten zu ermöglichen, bei der ein Überschreiten der maximalen Substrattemperatur verhindert wird und die einen hochqualitativen Substrattransport ermöglicht.

Diese Aufgabe wird durch eine Anordnung mit den Merkmalen des Anspruches 1 gelöst. Die Ansprüche 2 bis 16 zeigen Ausgestaltungen der erfindungsgemäßen Lösung.

In der erfindungsgemäßen Anordnung ist eine Abwickel- und eine Aufwickelrolle vorgesehen, zwischen denen das Foliensubstrat unter einer Bandzugspannung geführt wird. Dazwischen, d.h. zwischen Abwickel- und Aufwickelrolle ist eine Beschichtungsstation angeordnet. Dies Beschichtungsstation weist in dem Bereich eines Bandbeschichtungslaufes, in dem das Band zwischen der Abwickelrolle und Aufwickelrollen durch die Beschichtungsstation geführt wird, mindestens zwei in Richtung des Bandlaufes hintereinander liegende Beschichtungsquellen auf. Diese liegen einer Beschichtungsseite des Foliensubstrates gegenüber, d.h. sie sind in einem Abstand zu der Beschichtungsseite angeordnet.

Auf der anderen Seite des Substrates, d.h. auf dessen Rückseite, d.h. der Seite die im Foliensubstrat der Beschichtungsseite gegenüberliegt, ist zwischen zwei benachbarten Beschichtungsquellen ein Stützelement angeordnet, das eine auf die Rückseite des Foliensubstrates als Kraftkomponente aus der Bandzugspannung resultierende Stützkraft erzeugt. Über dieses Stützelement ist das Foliensubstrat frei gespannt. Werden mehrere Stützelemente vorgesehen, wie das in der Regel der Fall ist, dann ist das Foliensubstrat auch zwischen zwei Stützelementen frei gespannt. Gegenüber einer freiliegenden Oberfläche des Foliensubstrates und in einem Abstand zu dieser Oberfläche ist ein Wärme von dem Substrat absorbierendes Absorptionselement angeordnet. Durch dieses Absorptionselement wird die in das Foliensubstrat durch den Beschichtungsvorgang eingebrachte Wärme entzogen.

Üblicherweise sind mehr als zwei Beschichtungsquellen und entsprechende Stützelemente angeordnet, wobei das Foliensubstrat im Bandbeschichtungslauf eine Fläche aufweist, die in Querschnitt einem Polygonzug folgt.

Das Absorptionselement kann beschichtungsseitig oder rückseitig angeordnet sein.

Bei der beschichtungsseitigen Anordnung ist vorgesehen, dass das Absorptionselement zwischen zwei benachbarten Beschichtungsquellen der Beschichtungsseite gegenüber liegend angeordnet ist.

Bei der rückseitigen Anordnung ist vorgesehen, dass das Absorptionselement im Bereich einer Beschichtungsquelle der Rückseite gegenüber liegend angeordnet ist.

Es ist hierbei auch möglich, dass auf beiden Seiten je ein oder mehrere Absorptionselement angeordnet sind, wodurch die Kühlwirkung erheblich erhöht werden kann.

Es ist möglich, das Absorptionselement als ein von einem Kühlmittel durchströmtes Kühlelement auszubilden. Damit kann die von dem Absorptionselement aufgenommene Wärme kontrolliert abgeführt werden.

Es ist zweckmäßig, wenn zumindest ein Stützelement als mit ihrer Drehachse quer zur Bewegungsrichtung des Foliensubstrates liegende Stützwalze ausgebildet ist.

Einer solchen Stützwalze kann eine zusätzliche Funktion zukommen, indem beispielweise die Stützwalze als Kühlwalze ausgebildet ist. Auch diese kann von einem Kühlmittel durchflossen ausgebildet sein.

Foliensubstrate sind hinsichtlich der Bahnführung sehr sensibel. Sie können schnell weglaufen oder zu Verzerrungen neigen. Wenn die die Stützwalze als ballig geformte Breitstreckwalze ausgebildet ist, kann eine exakte Bahnführung unterstützt werden.

Da sich das oder die Stützelemente auf der Rückseite des Foliensubstrates befinden, ist es möglich, dass zumindest ein Stützelement als ein quer zur Bewegungsrichtung des Foliensubstrates liegender Gleitstein ausgebildet ist.

Grundsätzlich ist es auch möglich, dass zumindest ein Stützelement als ein die Stützkraft auf die Rückseite berührungslos aufbringendes Stützelement ausgebildet ist. Dies kann durch ein ein Luftkissen zwischen der Rückseite und dem Stützelement erzeugendes Gasströmungselement realisiert werden, insbesondere dann, wenn sich das Stützelement außerhalb des Vakuums der Beschichtungsstation befindet.

Eine andere Möglichkeit besteht darin, ein Magnetkissen zu erzeugen, indem das Stützelement als ein einen Abstand zwischen der Rückseite einer ferromagnetischen Metallfolie als Foliensubstrat und dem Stützelement erzeugendes Magnetelement ausbildet ist.

Es ist darüber hinaus auch möglich, dass das Stützelement als ein einen Abstand zwischen der Rückseite und dem Stützelement erzeugendes elektrostatisches Element ausbildet ist.

Grundsätzlich erfolgt die Anordnung von Bandwickeleinrichtungen, Bandumlenkrollen und Bandkühlrollen so, dass immer nur die Bandrückseite von Rollen berührt wird. Dies wird erreicht, indem die Lage aller Rollen so gewählt ist, dass der durch Dichte und Bandzugspannung des Bandmateriales definierte theoretische Durchhang des Bandes in vertikaler Richtung immer oberhalb der jeweiligen Rollenposition liegt.

Die Beschichtungsrate wird so gesteuert, dass in Abhängigkeit von Substratdicke, spezifischer Wärmekapazität und Substratgeschwindigkeit eine maximal zulässige Substrattemperatur nicht überschritten wir. Benachbarte Beschichtungsquellen werden dabei so angeordnet, dass sich das Substrat vor Erreichen der der ersten folgenden Beschichtungsquelle mittels geeigneter Absorptionsflächen bzw. Absorptionselemente um den zu erwartenden Temperaturanstieg der der ersten Beschichtungsquelle folgenden weiteren Beschichtungsquelle ausreichend abkühlen kann.

Durch die Erfindung wird eine Anordnung, ein Antrieb und eine Steuerung der Oberflächentemperatur von aktiven Bandkühleinrichtungen (Kühlwalzen) so realisiert, dass störende Relativbewegungen zwischen Kühleinrichtung und Substrat ausgeschlossen sind. Außerdem wird durch die Gestaltung der Substratführung erreicht, dass über dem Bereich der Beschichtungsquelle oder der Beschichtungsquellen die Beschichtungsseite frei liegt. Auch bei der Rückseite des Substrats liegen große Oberflächenteile frei. Die freien Oberflächenteile auf der Beschichtungsseite und/oder der Rückseite erlauben die Anordnung von Absorptionselementen in einer solchen Nähe zu den Oberflächen, dass das Substrat durch Absorption der Strahlungswärme gekühlt wird. Eine Berührung und damit eine mögliche Oberflächenbeeinflussung oder gar -schädigung kann dadurch bei Gewährleistung einer Kühlung ausgeschlossen werden. Andererseits ist es durch den großen Anteil freiliegender Oberflächenbereiche möglich, große Oberflächenteile zu kühlen. Dies wiederum ermöglicht den Einsatz höherer Beschichtungsleistung, bzw. die Anwendung physikalischer Beschichtungsprozesse, wie z.B. PVD (Physical Vapor Depositon), die per se eine hohe thermische Substratbelastung mit sich bringen.

Durch die erfindungsgemäße Anordnung wird insbesondere die PVD-Beschichtung von dünnen Metallfolien ermöglicht. Dünne Metallfolien haben eine Dicke von kleiner 500µm.

Die Erfindung soll nachfolgend anhand eines Ausführungsbeispieles näher erläutert werden. Die zugehörige Zeichnung zeigt ein Prinzipschema einer erfindungsgemäßen Anordnung.

Ein Foliensubstrat 1 wird von einer Bandwickeleinrichtung 2 zwischen einer Abwickelrolle 7 und einer Aufwickelrolle mit einer Bandzugspannung F_{z} bewegt.

Gegenüber dem Foliensubstrat 1, d.h. gegenüber seiner Beschichtungsseite 9 sind Beschichtungsquellen 5 angeordnet.

Jeweils zwischen zwei benachbarten Beschichtungsquellen 5 sind Wärme absorbierende Absorptionselemente 6 angeordnet. Durch diese Absorptionselemente 6 wird ein Großteil der von jeder Beschichtungsquelle 5 in das Foliensubstrat 1 eingebrachten Wärme über Wärmestrahlung aufgenommen. Zur abschließenden Abkühlung ist am Ende des Bandbeschichtungslaufs 9 eine Bandkühlrolle 4 vorgesehen.

Auf der Rückseite 11 des Foliensubstrates 1 sind Stützrollen 3 angeordnet und zwar immer in einem Abstand von der direkten Verbindungslinie zweier benachbarter Rollen , der aus einem Kraftdreieck über die Bandzugspannung F_{z} eine Stützkraft Fₛ entstehen lässt, die das Foliensubstrat 1 leicht auf die Stützrollen 3 drückt.

Grundsätzlich ist es möglich, auch auf die Rückseite weitere Absorptionselemente 6 anzuordnen.

### Anordnung zum Beschichten bandförmiger Foliensubstrate

### Bezugszeichenliste

- 1: Foliensubstrat
- 2: Bandwickeleinrichtung
- 3: Stützrolle
- 4: Bandkühlrolle
- 5: Beschichtungsquelle
- 6: Absorptionselement
- 7: Abwickelrolle
- 8: Aufwickelrolle
- 9: Beschichtungsseite
- 10: Bandbeschichtungslauf
- 11: Rückseite
- F_{z}: Bandzugspannung
- Fₛ: Stützkraft

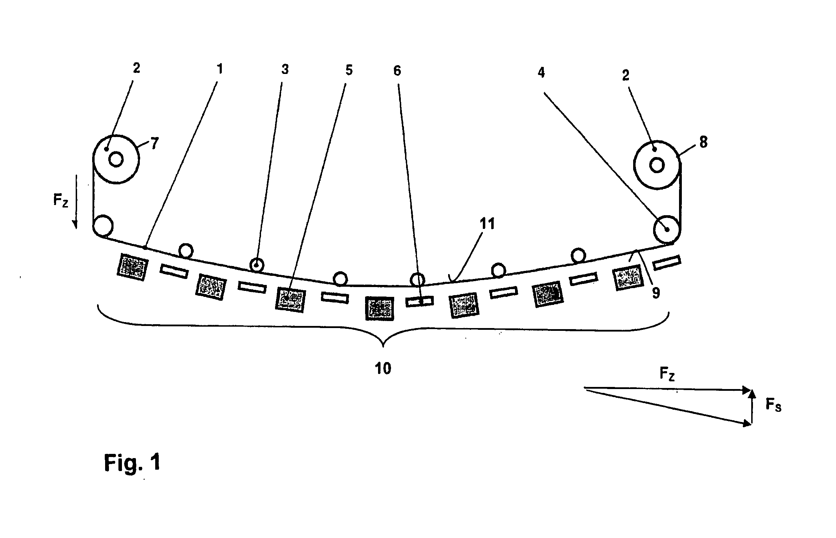

## Patentansprüche

1. Anordnung zum Beschichten bandförmiger Foliensubstrate (1) mit einer Abwickel- und einer Aufwickelrolle (7, 8) zwischen denen das Foliensubstrat unter einer Bandzugspannung geführt wird, und einer dazwischen angeordneten Beschichtungsstation,
wobei
die Beschichtungsstation in dem Bereich eines Bandbeschichtungslaufes, in dem das Band zwischen der Abwickelrolle und Aufwickelrollen (7,8) durch die Beschichtungsstation geführt wird, mindestens zwei in Richtung des Bandlaufes hintereinander und einer Beschichtungsseite des Foliensubstrates (1) gegenüber liegenden Seite angeordnete Beschichtungsquellen (5) aufweist, **dadurch gekennzeichnet daß**,
zwischen zwei benachbarten Beschichtungsquellen (5) auf einer der Beschichtungsseite gegenüberliegenden Rückseite des Foliensubstrates (1) ein eine auf die Rückseite des Folien-substrates als Kraftkomponente aus der Bandzugspannung resultierende Stützkraft erzeugendes Stützelement (3) angeordnet ist und
das Foliensubstrat (1) zwischen zwei Stützelementen (3) frei gespannt ist und
gegenüber einer freiliegenden Oberfläche des Foliensubstrates (1) und in einem Abstand zu dieser Oberfläche ein Wärme von dem Substrat absorbierendes Absorptionselement (6) angeordnet ist.

2. Anordnung nach Anspruch 1, **dadurch gekennzeichnet, dass** mehr als zwei Beschichtungsquellen und entsprechende Stützelemente angeordnet sind, wobei das Foliensubstrat im Bandbeschichtungslauf eine Fläche aufweist, die in Querschnitt einem Polygonzug folgt.

3. Anordnung nach Anspruch 1 oder 2, **dadurch gekennzeichnet, dass** das Absorptionselement zwischen zwei benachbarten Beschichtungsquellen der Beschichtungsseite gegenüber liegend angeordnet ist.

4. Anordnung nach einem der Ansprüche 1 bis 3, **dadurch gekennzeichnet , dass** das Absorptionselement im Bereich einer Beschichtungsquelle der Rückseite gegenüber liegend angeordnet ist.

5. Anordnung nach einem der Ansprüche 1 bis 4, **dadurch gekennzeichnet, dass** das Absorptionselement ein von einem Kühlmittel durchströmtes Kühlelement ist.

6. Anordnung nach einem der Ansprüche 1 bis 5, **dadurch gekennzeichnet, dass** auf beiden des Substrates je ein Absorptionselement angeordnet ist.

7. Anordnung nach einem der Ansprüche 1 bis 6, **dadurch gekennzeichnet, dass** mehrere Absorptionselement angeordnet sind.

8. Anordnung nach einem der Ansprüche 1 bis 4, **dadurch gekennzeichnet, dass** zumindest ein Stützelement als mit ihrer Drehachse quer zur Bewegungsrichtung des Foliensubstrates liegende Stützwalze ausgebildet ist.

9. Anordnung nach Anspruch 8, **dadurch gekennzeichnet, dass** die Stützwalze als Kühlwalze ausgebildet ist.

10. Anordnung nach Anspruch 9, **dadurch gekennzeichnet, dass** die Kühlwalze von einem Kühlmittel durchflossen ausgebildet ist.

11. Anordnung nach einem der Ansprüche 8 bis 10, **dadurch gekennzeichnet, dass** die Stützwalze als ballig geformte Breitstreckwalze ausgebildet ist.

12. Anordnung nach einem der Ansprüche 1 bis 4, **dadurch gekennzeichnet, dass** zumindest ein Stützelement als ein quer zur Bewegungsrichtung des Foliensubstrates liegender Gleitstein ausgebildet ist.

13. Anordnung nach einem der Ansprüche 1 bis 4, **dadurch gekennzeichnet, dass** zumindest ein Stützelement als ein die Stützkraft auf die Rückseite berührungslos aufbringendes Stützelement ausgebildet ist.

14. Anordnung nach Anspruch 13, **dadurch gekennzeichnet, dass** das Stützelement als ein Luftkissen zwischen der Rückseite und dem Stützelement erzeugendes Gasströmungselement ausbildet ist.

15. Anordnung nach Anspruch 13, **dadurch gekennzeichnet, dass** das Stützelement als ein einen Abstand zwischen der Rückseite einer ferromagnetischen Metallfolie als Foliensubstrat und dem Stützelement erzeugendes Magnetelement ausbildet ist.

16. Anordnung nach Anspruch 13, **dadurch gekennzeichnet, dass** das Stützelement als ein einen Abstand zwischen der Rückseite und dem Stützelement erzeugendes elektrostatisches Element ausbildet ist.

## Claims

1. Arrangement for coating tape-shaped film substrates (1), with an unwinding and a winding-up roller (7, 8), between which the film substrate is guided under tape tension, and with a coating station arranged between them, the coating station having, in the region of a tape coating run in which the tape is guided through the coating station between the unwinding and the winding-up rollers (7, 8), at least two coating sources (5) arranged one behind the other in the direction of the tape run and on a side lying opposite a coating side of the film substrate (1), **characterized in that** a supporting element (3) generating a supporting force resulting on the rear side of the film substrate as a force component from the tape tension is arranged between two adjacent coating sources (5) on a rear side of the film substrate (1) which lies opposite the coating side, and the film substrate (1) is freely tensioned between two supporting elements (3), and an absorption element (6) absorbing heat from the substrate is arranged opposite an exposed surface of the film substrate (1) and at a distance from this surface.

2. Arrangement according to Claim 1, **characterized in that** more than two coating sources and corresponding supporting elements are arranged, the film substrate having in the tape coating run an area which in cross section follows the line of a polygon.

3. Arrangement according to Claim 1 or 2, **characterized in that** the absorption element is arranged between two adjacent coating sources so as to lie opposite the coating side.

4. Arrangement according to one of Claims 1 to 3, **characterized in that** the absorption element is arranged in the region of a coating source so as to lie opposite the rear side.

5. Arrangement according to one of Claims 1 to 4, **characterized in that** the absorption element is a cooling element through which a coolant flows.

6. Arrangement according to one of Claims 1 to 5, **characterized in that** an absorption element is arranged on each of the two sides of the substrate.

7. Arrangement according to one of Claims 1 to 6, **characterized in that** a plurality of absorption elements are arranged.

8. Arrangement according to one of Claims 1 to 4, **characterized in that** at least one supporting element is designed as a supporting roller lying with its axis of rotation transverse to the direction of movement of the film substrate.

9. Arrangement according to Claim 8, **characterized in that** the supporting roller is designed as a cooling roller.

10. Arrangement according to Claim 9, **characterized in that** the cooling roller is designed to have coolant flowing through it.

11. Arrangement according to one of Claims 8 to 10, **characterized in that** the supporting roller is designed as an expanding roller of crowned shape.

12. Arrangement according to one of Claims 1 to 4, **characterized in that** at least one supporting element is designed as a sliding block lying transversely to the direction of movement of the film substrate.

13. Arrangement according to one of Claims 1 to 4, **characterized in that** at least one supporting element is designed as a supporting element which applies the supporting force to the rear side contactlessly.

14. Arrangement according to Claim 13, **characterized in that** the supporting element is designed as a gas flow element generating an air cushion between the rear side and the supporting element.

15. Arrangement according to Claim 13, **characterized in that** the supporting element is designed as a magnetic element generating a clearance between the rear side of a ferromagnetic metal film as the film substrate and the supporting element.

16. Arrangement according to Claim 13, **characterized in that** the supporting element is designed as an electrostatic element generating a clearance between the rear side and the supporting element.

## Revendications

1. Agencement pour revêtir des substrats de type feuilles en forme de bande (1), comprenant un rouleau de déroulement et un rouleau d'enroulement (7, 8) entre lesquels le substrat de type feuille est guidé avec une tension de traction de bande, et un poste de revêtement disposé entre eux, dans lequel
le poste de revêtement, dans la région d'un passage de revêtement de bande dans laquelle la bande est guidée entre le rouleau de déroulement et des rouleaux d'enroulement (7, 8) à travers le poste de revêtement, présente au moins deux sources de revêtement (5) disposées l'une derrière l'autre dans la direction de l'avance de la bande et d'un côté opposé au côté de revêtement du substrat de type feuille (1),
**caractérisé en ce**
**qu'**un élément de support (3) produisant une force de support résultant de la tension de traction de bande sur le côté arrière du substrat de type feuille en tant que composante de force est disposé entre deux sources de revêtement (5) adjacentes sur un côté arrière du substrat de type feuille (1) opposé au côté de revêtement, et en ce que le substrat de type feuille (1) est tendu librement entre deux éléments de support (3) et
un élément d'absorption (6) absorbant la chaleur du substrat est disposé en regard d'une surface exposée du substrat de type feuille (1) et à distance de cette surface.

2. Agencement selon la revendication 1, **caractérisé en ce que** plus de deux sources de revêtement et éléments de support correspondants sont prévus, le substrat de type feuille présentant dans la direction d'avance de revêtement de la bande une surface qui suit un tracé polygonal en section transversale.

3. Agencement selon la revendication 1 ou 2, **caractérisé en ce que** l'élément d'absorption est disposé entre deux sources de revêtement adjacentes en regard du côté de revêtement.

4. Agencement selon l'une quelconque des revendications 1 à 3, **caractérisé en ce que** l'élément d'absorption est disposé dans la région d'une source de revêtement en regard du côté arrière.

5. Agencement selon l'une quelconque des revendications 1 à 4, **caractérisé en ce que** l'élément d'absorption est un élément de refroidissement parcouru par un réfrigérant.

6. Agencement selon l'une quelconque des revendications 1 à 5, **caractérisé en ce qu'**un élément d'absorption respectif est disposé de chaque côté du substrat.

7. Agencement selon l'une quelconque des revendications 1 à 6, **caractérisé en ce que** plusieurs éléments d'absorption sont prévus.

8. Agencement selon l'une quelconque des revendications 1 à 4, **caractérisé en ce qu'**au moins un élément de support est réalisé sous forme de rouleau de support situé avec son axe de rotation transversalement à la direction de déplacement du substrat de type feuille.

9. Agencement selon la revendication 8, **caractérisé en ce que** le rouleau de support est réalisé sous forme de rouleau de refroidissement.

10. Agencement selon la revendication 9, **caractérisé en ce que** le rouleau de refroidissement est parcouru par un réfrigérant.

11. Agencement selon l'une quelconque des revendications 8 à 10, **caractérisé en ce que** le rouleau de support est réalisé sous forme de rouleau d'étirage de forme bombée.

12. Agencement selon l'une quelconque des revendications 1 à 4, **caractérisé en ce qu'**au moins un élément de support est réalisé sous forme de coulisseau situé transversalement à la direction de déplacement du substrat de type feuille.

13. Agencement selon l'une quelconque des revendications 1 à 4, **caractérisé en ce qu'**au moins un élément de support est réalisé sous forme d'élément de support appliquant sans contact la force de support sur le côté arrière.

14. Agencement selon la revendication 13, **caractérisé en ce que** l'élément de support est réalisé sous forme d'élément d'écoulement de gaz produisant un coussin d'air entre le côté arrière et l'élément de support.

15. Agencement selon la revendication 13, **caractérisé en ce que** l'élément de support est réalisé sous forme d'élément magnétique produisant un écartement entre le côté arrière d'un film métallique ferromagnétique servant de substrat de type feuille et l'élément de support.

16. Agencement selon la revendication 13, **caractérisé en ce que** l'élément de support est réalisé sous forme d'élément électrostatique produisant un écartement entre le côté arrière et l'élément de support.
